# EUROPEAN PATENT SPECIFICATION

(11) **EP 2 351 058 B1**
(45) Date of publication and mention of the grant of the patent: **01.05.2019**
(21) Application number: 09823136.8
(22) Date of filing: 02.03.2009
(51) Int. Cl.: H01G 4/32, H02M 7/48, H01G 4/28, H01G 4/38, H01G 4/14, H02M 7/00, H05K 7/14

(54) **ANNULAR CAPACITOR WITH POWER CONVERSION COMPONENTS**
RINGKONDENSATOR MIT LEISTUNGSUMWANDLUNGSKOMPONENTEN
CONDENSATEUR ANNULAIRE INTÉGRANT DES COMPOSANTS DE CONVERSION DE PUISSANCE

(30) Priority: 30.10.2008 US 807310
(43) Date of publication of application: 03.08.2011
(73) Proprietor: Sawyer, Ed, Barre, Vermont 05641 (US); Hosking, Terry, Barre, Vermont 05641 (US)
(72) Inventor: HOSKING, Terry, Barre, Vermont 05641 (US)
(74) Representative: Richards, John
(86) International application number: PCT/IB2009/005434
(87) International publication number: WO 2010/049764

(56) References cited:
- EP-A1- 1 244 199
- WO-A1-2007/094162
- US-A- 4 264 943
- US-A1- 2004 037 058
- US-A1- 2005 275 385
- US-A1- 2006 097 365
- US-B2- 7 289 311

## Description

This application is based on U.S. Provisional Applications Ser. Nos. 60984561, 60984546, and 60984530 filed Nov. 1, 2007 and entitled, respectively, "Annular capacitor with semiconductors around the perimeter to perform power conversion", "Annular capacitor with semiconductor die or modules inside the hole for power conversion", and "Annular capacitor with power conversion semiconductor electronics contained inside the center hole". The invention herein follows from the same inventor's recent patent, 7,289,311, "Power ring pulse capacitor" issued 30 Oct 2007.

### BACKGROUND OF THE INVENTION

### FIELD OF INVENTION

The invention relates to an annular form factor capacitor when used as the DC link capacitor in power conversion electronics. More specifically it relates to the arrangement options for placement of power switching devices around or inside said capacitor which result in the lowest capacitor internal temperature rise for a given capacitor current. Lower internal temperature will result in reliability improvement. Another way of stating the advantages of these configuration options will be the higher current allowed through the capacitor for a given temperature rise. These arrangement options also allow lower inductance connections between the DC link capacitor and the semiconductor switches than typical prior art.

### DESCRIPTION OF THE PRIOR ART

In broadly applied power conversion technology for conversion of DC voltages, or inversion of DC to AC, the typical circuit arrangement makes use of a capacitor located as close as practical to the switching semiconductor devices. This capacitor is used to reduce the impedance of the DC source as seen by the switching devices. This capacitor is required for several reasons.
1) It supplies current to the conversion/inversion switches at the switch frequency used. This removes the otherwise high frequency current from the DC source, where it is often detrimental to the lifetime and reliability of this source.
2) It removes most of the "noise" caused by the switching action and helps contain it within the power conversion/inversion enclosure.
3) Its low inductance to the switches reduces the voltage rise at the switches during the switch turn-off time, which is a major problem for inverter/converter designers.

This capacitor also stores energy so that short-term interruption of the DC source will not interrupt the output, but that function is not relevant to the proposed invention.

In the known art of power conversion/inversion a capacitor used in this application is known as the "DC link capacitor". This capacitor is usually sized based on the magnitude of AC current at the switching frequency that must be supplied by the capacitor to the switches, and by the maximum AC current that is acceptable to the application DC source. For large power conversion systems, the capacitor winding machines commercially available as of 15 Oct 08 are unable to wind a single capacitor element large enough to meet the DC link capacitor need. Suitable capacitors are made by interconnecting 2 or more capacitor windings to obtain the desired voltage and AC current carrying requirements. This can be done by a capacitor manufacturer, with the completed assembly enclosed within a metal or plastic container with at least one terminal pair for connection to the power conversion system. The DC Link capacitor can also be a "bank" of several suitably configured discrete capacitors.

For both of these implementations [internally connected capacitor windings, or externally connected capacitors] it is nearly impossible to ensure that each capacitance element will carry the same current because that would imply equal impedance connections from the switch semiconductors to each capacitor element. The capacitor windings nearest [thus having lowest impedance to] the switches will carry disproportionate current with resulting disproportionate heating. The closest capacitors to the switch semiconductors will capture the largest share of the resulting AC current.

The prior art performance limitation for an assembled DC link capacitor implementation is that the temperature rise in the capacitor element carrying the most current will define the current carrying capability of the entire capacitor; it is difficult to minimize the inductance between the capacitor elements and the switch semiconductors.

For the user assembled "capacitor bank" DC link capacitor, the same problem exists, the individual capacitors in the bank located closest to the switch semiconductors will carry more than their share of the current. This is because the closest capacitors will have the shortest distance to the current source and thus the lowest impedance in the circuit.

The long-term reliability of a capacitor is a function of the hottest spot in the capacitor under the current load conditions. The weaknesses and eventual failure will occur in this area. Thus, the long-term reliability of the capacitor will be a function of the hottest spot within the capacitor.

EP1244199 (A1) discloses a tubular motor (1) used to drive rolling shutters or blinds, which has an extended frame (4) which serves as a support from a wall bracket (11) and also houses the necessarily large motor capacitor (5). The motor capacitor is built as a ring and the inner space is used to accommodate ancillary motor control equipment such as an electronic card (7).

WO2007094162 (A1) discloses simplifying the connection between the terminals of three-phase electric parts used in a matrix converter to thereby reduce the inductance between conductors. An AC capacitor (10) and an IGBT (20) are disposed such that the linearly arranged terminals (11) of the AC capacitor (10) and the linearly arranged input terminals (21) of the IGBT (20) are parallel to each other, and also that the three terminals of the AC capacitor (10) and the three input terminals of the IGBT (20) are situated close to each other. A bus bar is formed as a laminate bus bar (100) which can be provided by laminating three plate-shaped bus bars on top of each other. In the respective plate-shaped bus bars, there are provided internal terminals for connecting together the mutually adjoining ones of the three-portion terminals of the AC capacitor (10) and the three-portion input terminals of the IGBT (20), and the mutually adjoining terminals are connected together through the internal terminals.

US2006097365 (A1) discloses a semiconductor package that features a ring-shaped silicon decoupling capacitor that reduces simultaneous switching noise. The decoupling capacitor is fabricated on a substrate from silicon using a wafer fabrication process and takes the form of an annular capacitive structure that extends around a periphery of a substrate-mounted integrated circuit (IC). The decoupling capacitor has a reduced thickness on or below a chip level and takes the place of a conventional power/ground ring. Therefore, the decoupling capacitor can be disposed within the package without increasing the thickness and the size of the package. The decoupling capacitor may be coupled to various power pins, allowing optimum wire bonding, shortened electrical connections, and reduced inductance. Bonding wires connected to the decoupling capacitor have higher specific resistance, lowering the peak of the resonance frequency and thereby reducing simultaneous switching noise.

US2005275385 (A1) discloses a wound, metallized dielectric film capacitor for pulsed power applications. The capacitor consists of a wound metallized polymer film in the shape of a closed path ring. The electrical load is placed within the inner opening of the capacitor. The capacitor has low inductance and resistance, scales to high energy levels, and can be formed around the electrical load.

### BRIEF SUMMARY OF THE INVENTION

The invention is defined by the enclosed claims. In embodiments of the present invention, the DC Link capacitor is an annular form factor [ring shaped] capacitor. In embodiments of the invention, the power semiconductor switches are arranged in a way to more evenly distribute the switched current around the area of the capacitor shape. By more evenly distributing the current around the annular shape, the current density at any one connection point is reduced by the number of equally arranged connection points attached to the capacitor. This reduced current density at any one connection point directly reduces the non uniformity of current density within the capacitor, with the result of more uniform losses and reduced temperature rise at any point for a given total capacitor current.

One advantage of embodiments of the invention is low heat dissipation for a given switching current.

Another advantage of embodiments of the invention is the increased long term reliability of the DC Link capacitor for any given capacitor current; the capacitor reliability is a function of hot spot temperature: lowering the temperature by 10C will, on average, improve the reliability by a factor of 2.

Another advantage of embodiments of the present invention is a very low Effective Series Inductance [ESL]. The short distances from capacitor to switches result in low inductance, which reduces voltage overshoot seen by the switch devices when they turn off.

Another related advantage offered by the low ESL is the possible elimination of the need for additional snubber capacitors across the terminals of the power semiconductor switches.

Another advantage of embodiments of the present invention is a very low Effective Series Resistance [ESR]. The more uniform current density within the capacitor results in less heating, which is reflected as lower ESR.

Another advantage is that a simplified connection bus structure is possible, and can be designed for weight, volume, and cost reduction.

Another advantage of embodiments of the present invention is that the power semiconductor switches connected to the capacitor can be placed within the hollow center of the capacitor, and be configured such that current in the capacitor is more equally distributed. The advantage is that the center area is an efficient location to place power semiconductor switches and will increase the power density of the inverter.

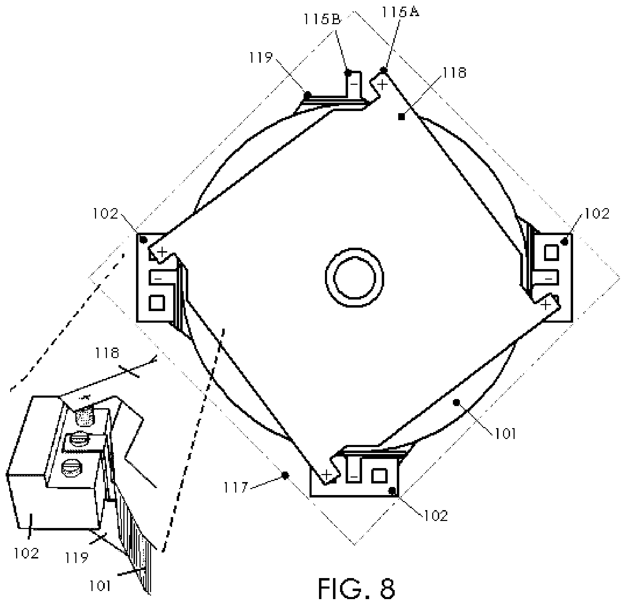

Another advantage of embodiments of the present invention is that the power semiconductor switches can be arranged in a such a way that a pair of 4 corner bus plates can be configured with 3 semiconductor switches and a DC input as shown in figure 8 to reduce cost, volume, and weight.

Another advantage of embodiments of the present invention as embodied in figure 8 is that it can be manufactured using simple techniques, resulting in low cost and good repeatability.

### BRIEF DESCRIPTION OF THE SEVERAL VIEWS OF THE DRAWING

FIG. 1 is a top view of the annular capacitor with a single power conversion component configured as taught in the patent.
FIG. 1B is a side view cross-section of the capacitor in FIG. 1
FIG. 2 is a top view of the annular capacitor with a single power conversion component configured for low temperature rise.
FIG. 3 is a top view of the annular capacitor with three power conversion components configured for low inductance and low capacitor temperature rise.
FIG. 4 is a cross-sectional side view of the annular capacitor showing a portion of the assembly and detailing the connections of the semiconductor switching die mounted in the center hole and attached to a cold plate. [integrated capacitor/switch assembly]
FIG. 5 is a cross-sectional side view of the annular capacitor showing a portion of the assembly and detailing the connections of the semiconductor switching die mounted in the center hole and electrically insulated from the cold plate. [integrated capacitor/switch assembly]
FIG. 6 is a top view of the annular capacitor with three power conversion components equally spaced around the outside edge for low inductance and low temperature rise.
FIG. 7 is a top view of the annular capacitor with a space effective arrangement of three power conversion components and the DC input.
FIG. 8 is a top view of the annular capacitor of FIG. 7 further refined with the offset bus plates offering convenient connections between the capacitor, the three power conversion components and the DC input. This figure includes an enlarged, angled partial view for detail clarification.
FIG. 9 is a top view of the annular capacitor with three power conversion components equally spaced around the outside edge for low inductance and low temperature rise with the DC input located at the center hole.

### DETAILED DESCRIPTION OF THE INVENTION

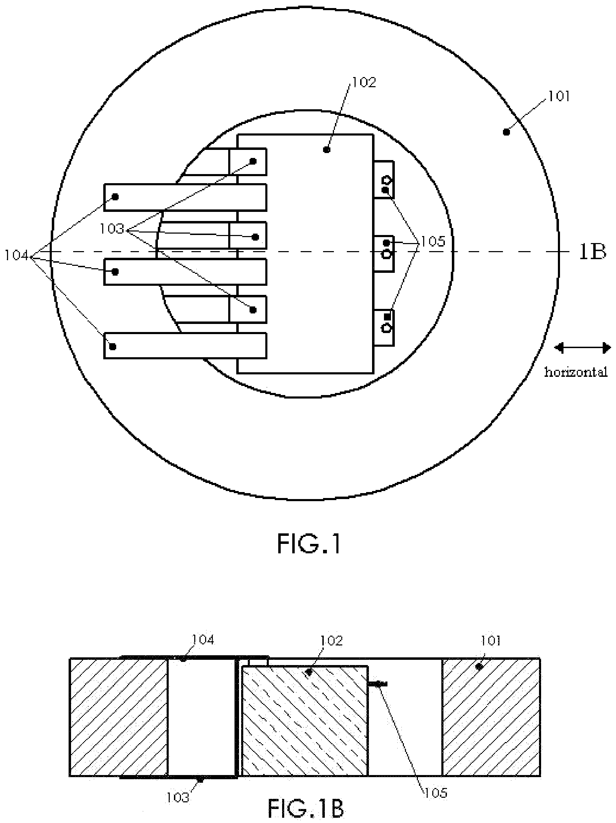

A metallized film polymeric annular capacitor with a single power conversion component is shown in FIG. 1. The annular capacitor body **101** has a variable center hole radius that can be made to fit a power conversion component **102** to exact specifications with the necessary space for the upper terminals **104,** lower terminals **103,** and output terminals **105** of the component. In FIG. 1 the terminals are positioned for the shortest path possible with a typical, commercially available power conversion component. The outer radius and thickness of the annular capacitor can then be selected to achieve the desired capacitance for the power conversion application. The thickness of the annular capacitor is addressed in FIG. 1B. The depth of the annular capacitor **101** is made to match the height of the power conversion component **102** so that the terminals **103 and 104** can maintain the shortest distance for connection to the capacitor, and thereby the lowest connection inductance possible for this configuration. It is to be understood that the illustrated power conversion component is but one of many existing or future commercially available power conversion components that could be similarly accommodated within the capacitor center hole.

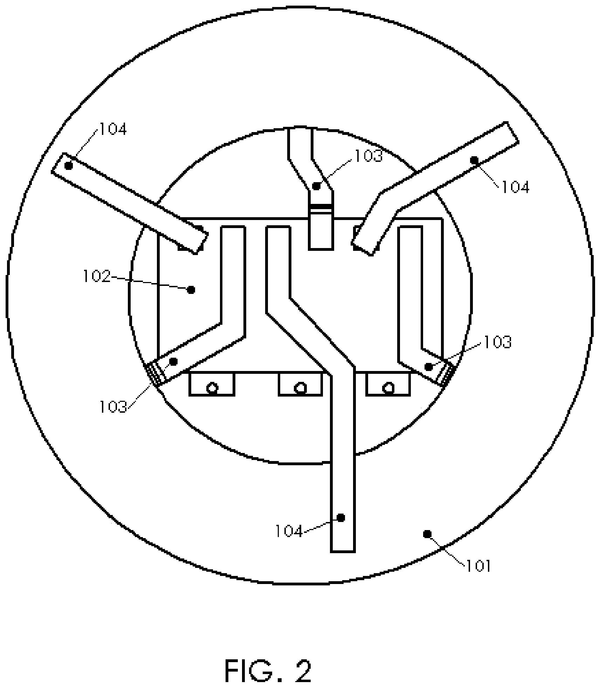

The annular capacitor in FIG. 2 shows a single power conversion component **102** again in the center hole of the capacitor body **101.** The upper terminals **104** and lower terminals **103** in this example are distributed equally spaced around the ring. This arrangement does not provide the shortest connection path, but will better distribute the capacitor current which will reduce the annular capacitor temperature rise. Again the depth of the annular capacitor would match the height of the power conversion component, as was shown in FIG. 1B. The thickness and inner radius of the capacitor being thus determined, the outer radius would vary to produce the desired capacitance. In practice, a compromise decision must be made concerning terminal placement as to which is more important to an application regarding temperature rise vs. low connection inductance. It should be noted that variation of capacitor width/shape may be implemented while still meeting the intent of more uniform current density within the capacitor.

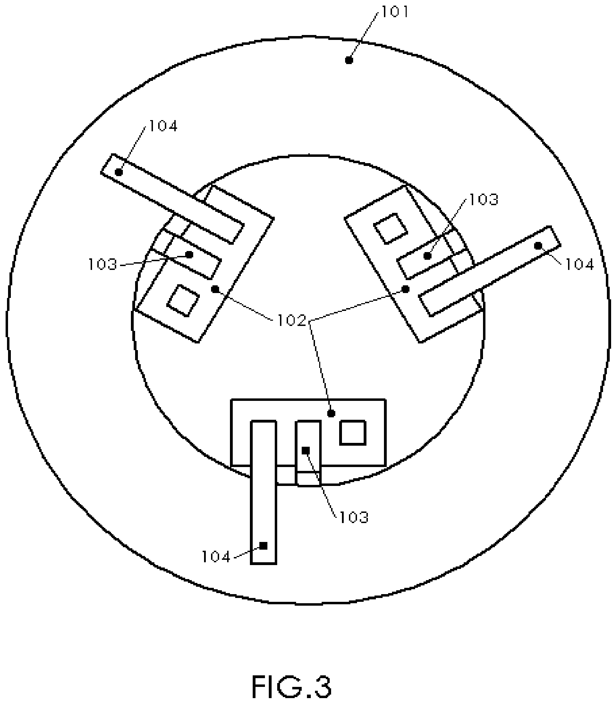

Depending on the application it may be advantageous to use more than one power conversion component. An example of a three point connection method for a three-phase inverter minimizing both capacitor temperature rise and connection inductance is shown in FIG. 3. The power conversion components **102** are located within the inner hole of the annular capacitor body **101.** The radius of the inner hole is determined by the size of the components used. In this embodiment the components are positioned to better distribute the capacitor current. This will minimize the temperature rise in the annular capacitor. Matching the depth of the ring to the height of the components, as was shown in FIG. 1B, will also take advantage of using the shortest path possible for the connections of the terminals **104** and **103** and thereby also result in the lowest connection inductance. It is to be understood that the illustrated arrangement of components is but one example of any number or size of the commercially available power conversion components that could be similarly accommodated.

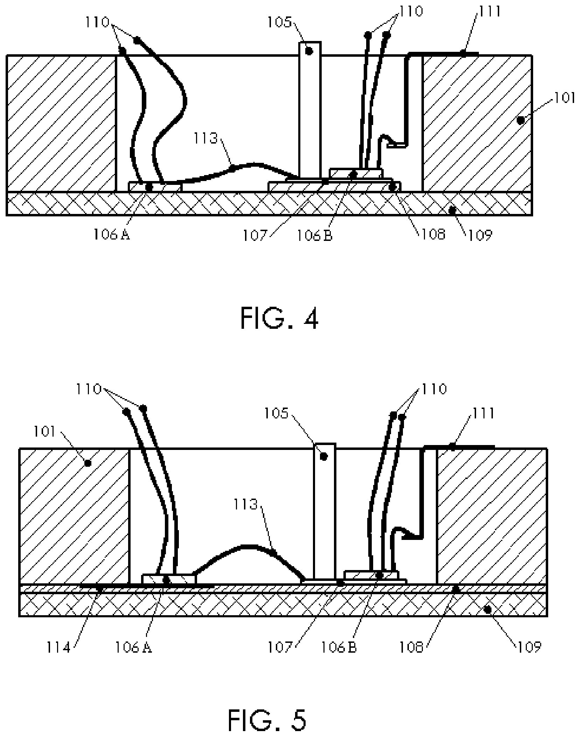

FIG. 4 is a cross section view that illustrates an embodiment where the capacitor and semiconductor switches are integrated into a single unit to achieve better space efficiency than can be had using separate commercially available packaged power conversion components. The semiconductor switching die **106A** and **106B** are representative in part or in whole of what would normally be contained within a commercially packaged semiconductor device [such as is simplistically illustrated in FIG. 3, reference **102**]. The components are located in the center hole of the annular capacitor **101.** In this embodiment one semiconductor switching die **106A** is directly connected to the cold plate **109,** which is in turn directly connected to the bottom face of the capacitor. This becomes, in effect, the lower terminal referred to in previous drawings. With the first semiconductor switching die **106A** connected to the cold plate it is necessary for the second semiconductor switching die **106B** to be electrically isolated from the electrically active cold plate. This is accomplished with a layer of thermally conductive electrically insulating material **108.** This semiconductor switching die **106B** is connected **111** to the upper face of the capacitor and is effectively the upper terminal referred to in previous drawings. Semiconductor switching die **106B** is connected to the output terminal **105** by a small conductive copper plate **107.** The switch semiconductor drive and return bond wires **110,** and multiple emitter bond wires **113** are shown to make the drawing more clear and credible. It is to be understood that this illustration shows only a portion of the power conversion components that would be well known to those skilled in the art. It is to be further understood that any number of components may be crafted and used within the ring as shown and described in FIG. 4.

FIG. 5 is a cross section view that illustrates another embodiment where the capacitor and semiconductor switches are integrated into a single unit to achieve better space efficiency than can be had using separate commercially available packaged power conversion components. The semiconductor switching die **106A** and **106B** are representative in part or in whole of what would normally be contained within a commercially packaged semiconductor device [such as is simplistically illustrated in FIG. 3, reference **102**]. The components are located in the center hole of the annular capacitor **101.** In this embodiment the thermally conductive electrically insulating layer **108** covers the entire surface between the capacitor **101** and the cold plate **109.** Semiconductor switching die **106A,** connected to the capacitor by a small conductive plate **114,** is effectively the lower terminal referred to in previous drawings. As in FIG. 4, semiconductor switching die **106B** is connected **111** to the upper face of the capacitor and is effectively the upper terminal referred to in previous drawings. Semiconductor switching die **106B** is connected to the output terminal **105** by a small conductive copper plate **107.** The switch semiconductor drive and return bond wires **110,** and multiple emitter bond wires **113** are shown to make the drawing more clear and credible. It is to be understood that this illustration shows only a portion of the power conversion components that would be well known to those skilled in the art. It is to be further understood that any number of components may be crafted and used within the ring as shown and described in FIG. 5.

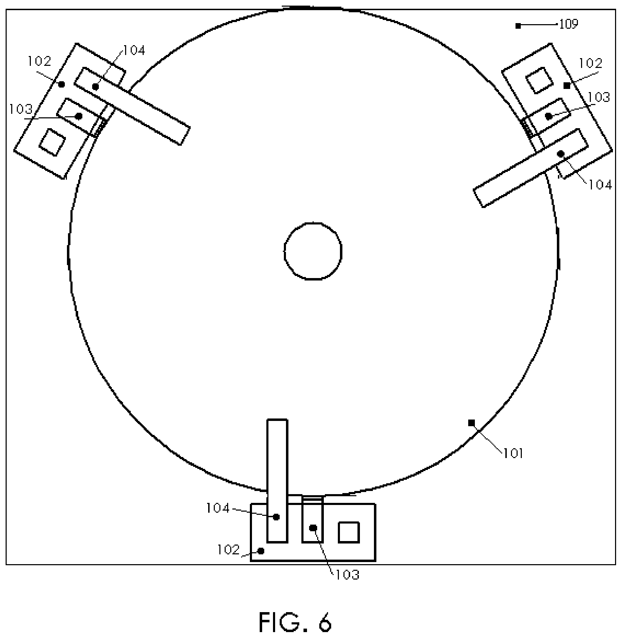

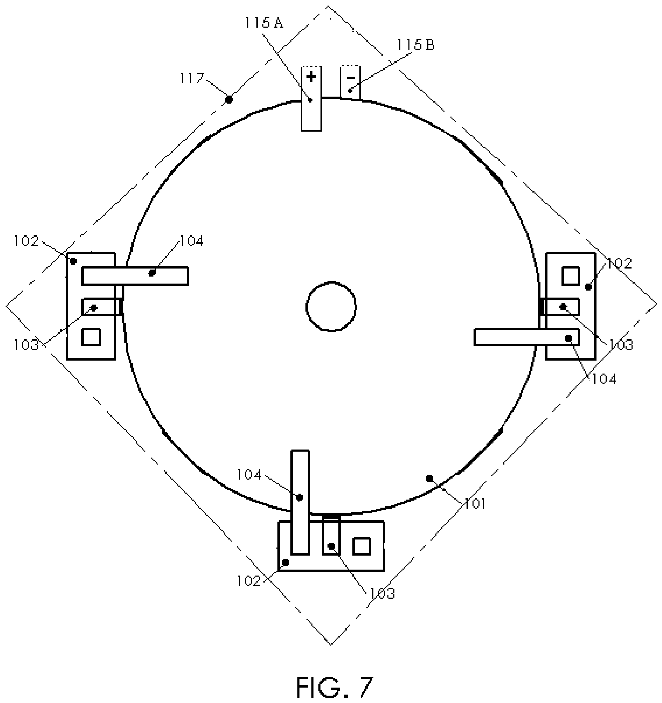

A different embodiment where the power conversion components **102** are distributed around the outside circumference of the capacitor **101** on a cold plate **109** is shown in FIG. 6. In the illustrated three-phase inverter example the resulting capacitor current distribution will be spaced symmetrically around the capacitor outer circumference. This would produce the same capacitance value as the embodiments shown in FIG. 1-5 with a smaller ring diameter. Matching the depth of the ring to the height of the components, as was exemplified by FIG. 1B, will also take advantage of the shortest connection length of the terminals **104** and **103** resulting in low inductance. Note that the connection length of the terminals **103 and 104** will be slightly shorter in this embodiment than for that illustrated in FIG. 3. It is to be understood that the illustrated arrangement of components is but one example of any number or size of the commercially available power conversion components that could be similarly located around the capacitor to achieve more uniform current density within the capacitor for any power conversion application. The enclosure line **117** of FIG. 7 suggests an arrangement of switching semiconductors **102** around the annular capacitor **101.** This allows more space efficient usage of a power conversion enclosure volume. In the illustrated case the outer perimeter of the capacitor is divided equally between the power conversion components and the DC Input. DC Input terminals **115A and 115B** are located in one quadrant, and the three power conversion components **102** are located in the other three quadrants. The switching components **102** are not as evenly distributed around the entire capacitor **101** as was shown in FIG. 6, but the resulting capacitor current distribution is still much more uniform than shown in FIG. 1, and the trade off for the significant space efficiency gains is minimal. Again the depth of the ring matches the height of the components so that the upper terminals **104** and lower terminals **103** can obtain the advantage of short connection length [low inductance]. While the drawing shows a three-phase inverter and single input terminal pair, it is to be understood that any number of components or DC input terminal pairs may be similarly distributed to reap the benefits of the stated advantages within any given space efficient arrangement. Inner and outer radii, and depth of the annular capacitor will be determined by the components used and the requirements of the application as described above.

FIG. 8 further refines the space efficient arrangement of components as described in FIG. 7. The enclosure line **117** defines the space. The capacitor **101** is sandwiched between two bus plates. The top bus plate **118** provides a convenient way to connect the positive DC Input **115A** and the positive terminals of the power conversion components. The bottom bus plate **119** provides a convenient way to connect the negative DC Input **115B** and the negative terminals of the power conversion components. Inner and outer radii, and depth of the annular capacitor will be determined by the components used and the requirements of the application as described above. Included in FIG. 8 is an enlarged, angled view detailing the connections between a power conversion component **102,** the capacitor **101,** and the top and bottom bus plates **118 and 119.**

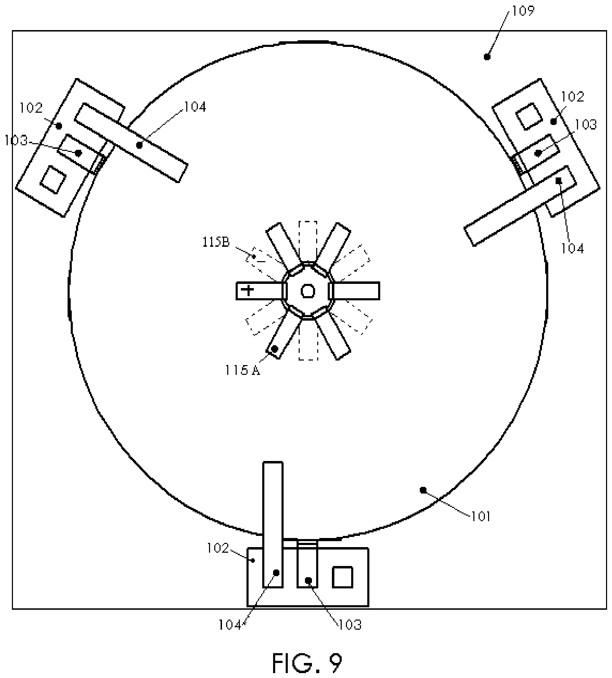

As illustrated in FIG. 9 the DC Input to the assembly can be attached via the center hole of the capacitor **101,** with the connection points evenly distributed. The positive DC Input **115A** is attached to one side of the capacitor and the negative DC Input **115B** to the other side of the capacitor. The power conversion components **102** are distributed around the perimeter to take advantage of the benefits as described for FIG. 6. To further increase the capacitor low temperature rise advantage the negative DC Input **115B** to the assembly can be connected using a cold plate 109 as an input connection and thusly distributing the current equally across the face of the capacitor. The positive DC Input 115A would be connected as above. Ultimately the DC Input connections could be a disc shape attached to the entire inner circumference of the capacitor. While the drawing shows a three-phase inverter, it is to be understood that any number of power conversion components may be similarly distributed around a centrally located DC Input to achieve minimum overall temperature rise in the capacitor. Inner and outer radii, and depth of the annular capacitor will be determined by the components used and the requirements of the application as described above.

## Claims

1. An electrical power inverter assembly, comprising:
a wound film DC link capacitor (101) in the form of an annular ring having an outer diameter that is greater than a thickness of said annular ring and an inner diameter, said annular ring having a depth;
a plurality of electrically conductive contacts (103, 104) distributed equally around the annular ring (101) on opposing end faces of said DC link capacitor (101); and **characterized in that** it comprises
one or more electrical power control components (102; 106A, 106B) distributed around an inner or outside circumference of said annular ring and electrically connected with said contacts (103, 104) on said DC link capacitor (101) to effect a reduction in circuit inductance and to uniformly distribute current flow in the DC link capacitor (101) in order to minimize power losses therein, and said annular ring depth being selected to minimize the length of said electrical connection between each of the electrical power control components and said electrically conductive contacts to which it is connected.

2. An electrical power inverter assembly as in claim 1 further comprising one or more printed circuit boards (109) selectively connected to said plurality of electrically conductive contacts (103, 104) on said DC link capacitor (101) and to said one or more electrical power control components (102; 106A, 106B) for effecting said electrical connection therebetween.

3. An electrical power inverter assembly as in any of claims 1 and 2, further comprising one or more thermally and electrically conductive plates (109; 118, 119) for providing an electrical and thermal connection to one or both of said opposing end faces of said DC link capacitor (101).

4. An electrical power inverter assembly of claim 3, further comprising one or more layer of electrically insulating and thermally conductive material (108) between one or both of said opposing end faces of said capacitor (101) and said thermally and electrically conductive plates for providing electrical insulation therebetween.

5. An electrical power inverter assembly as in any of claims 1-4 **characterized in that** one or more electrically and thermally conductive endplates (109) are connected to the opposing end faces of said capacitor (101), where said endplates (109) are substantially larger than the end faces of said capacitor(101), where said endplates (109) are positioned to be offset from each other, where the said plates have tabs or flanges that extend beyond the outer diameter of the outer circumference of said capacitor for the purpose of connecting to said electrical power control components (102; 106A, 106B), and where said electrical power control components are fastened to said endplates.

6. An electrical power inverter assembly as in claim 5 **characterized in that** said electrical assembly is designed to control both direct current and alternating current electrical power flows, where the direct current introduced to the assembly is connected to one or more of the said tabs or flanges on the said endplates (109) to optimize the heat dissipation from the combination of AC and DC current in the assembly.

7. An electrical power inverter assembly as in claim 6 **characterized in that** said endplates (109) are fastened to one or more thermally conductive cooling plates using an electrically insulating and thermally conductive layer (108).

8. An electrical power inverter assembly as in any of claims 1 and 2, further comprising a first DC electrical connection (115A) located within said inner diameter on a first one of said opposing end faces of said DC link capacitor (101) and a second DC electrical connection (115B) located within said inner diameter on a second one of said opposing end faces of said DC link capacitor (101), a plurality of DC connection points being equally distributed around said inner circumference of said capacitor (101), said electrically conducting contacts comprising an array of electrical tabs or a disc-shaped continuous electrode.

9. An electrical power inverter assembly as in any of claims 2 to 8 **characterized in that** direct current is introduced to or removed from said assembly through an electrical connection formed by an electrically and thermally conductive cold plate (109) placed in contact with one end face of said capacitor (101), where direct current is removed from or introduced to said assembly through an electrical connection (105) located within the inner diameter on the opposite end face of said capacitor (101), where the direct current connection points are equally distributed around the inner circumference of said capacitor, and where the direct current contacts are selected from the list including electrical tabs or a disc shaped continuous electrode.

10. An electrical power inverter assembly as in any of claims 1, 2, and 8 wherein said wound film DC link capacitor (101) comprises a monolithic wound film capacitor.

11. An electrical power inverter assembly as in any of claims 1, 2, and 8, further comprising a thermally and electrically conducting cold plate (109) connected to said electrically conducting contacts and to said one or more electrical power control components (102; 106A, 106B) for providing said electrical connection therebetween.

## Patentansprüche

1. Elektrische Wechselrichtereinheit, die folgendes umfasst:
einen DC-Link-Kondensator (101) mit gewickelter Folie in Form eines Rings mit einem äußeren Durchmesser, der größer ist als eine Dicke des Rings, und mit einem inneren Durchmesser, wobei der Ring eine Tiefe aufweist:
eine Mehrzahl elektrisch leitfähiger Kontakte (103, 104), die an entgegengesetzten Stirnseiten des DC-Link-Kondensators (101) gleichmäßig um den Ring (101) verteilt sind; und **dadurch gekennzeichnet, dass** die Einheit folgendes umfasst:
eine oder mehrere elektrische Leistungssteuerungskomponenten (102; 106A, 106B), die um einen inneren oder äußeren Umfang des Rings verteilt und elektrisch mit den Kontakten (103, 104) an dem DC-Link-Kondensator (101) verbunden sind, um eine Reduzierung der Schaltkreisinduktivität zu bewirken und um den Stromfluss in dem DC-Link-Kondensator (101) gleichmäßig zu verteilen, um Leistungsverluste darin zu minimieren, und wobei die Ringtiefe so ausgewählt ist, dass sie die Länge der elektrischen Verbindung zwischen jeder der elektrischen Leistungssteuerungskomponenten und den elektrisch leitfähigen Kontakten zu minimieren, mit denen eine Verbindung besteht.

2. Elektrische Wechselrichtereinheit nach Anspruch 1, diese ferner eine oder mehrere gedruckte Leiterplatten (109) umfasst, die selektiv mit der Mehrzahl elektrisch leitfähiger Kontakte (103, 104) an dem DC-Link-Kondensator (101) und mit der einen oder den mehreren elektrischen Leistungssteuerungskomponenten (102; 106A, 106B) verbunden sind, um die elektrische Verbindung dazwischen aufzubauen.

3. Elektrische Wechselrichtereinheit nach Anspruch 1 oder 2, wobei diese ferner eine oder mehrere thermisch und elektrisch leitfähige Platten (109; 118, 119) umfasst, um eine elektrische und thermische Verbindung mit einer oder beiden entgegengesetzten Stirnseiten des DC-Link-Kondensators (101) bereitzustellen.

4. Elektrische Wechselrichtereinheit nach Anspruch 3, wobei diese ferner eine oder mehrere Schichten eines elektrisch isolierenden und thermisch leitfähigen Materials (108) zwischen einer oder beiden entgegengesetzten Stirnseiten des Kondensators (101) und den thermisch und elektrisch leitfähigen Platten umfasst, um eine elektrische Isolierung dazwischen bereitzustellen.

5. Elektrische Wechselrichtereinheit nach einem der Ansprüche 1 bis 4, **dadurch gekennzeichnet, dass** eine oder mehrere elektrisch und thermisch leitfähige Endplatten (109) mit den entgegengesetzten Stirnseiten des Kondensators (101) verbunden sind, wobei die Endplatten (109) deutlich größer sind als die Stirnseiten des Kondensators (101), wobei die Endplatten (109) voneinander versetzt positioniert sind, wobei die Platten Ansätze oder Flansche aufweisen, die sich über den äußeren Durchmesser des äußeren Umfangs des Kondensators erstrecken, für eine Verbindung mit den elektrischen Leistungssteuerungskomponenten (102; 106A, 106B), und wobei die elektrischen Leistungssteuerungskomponenten an den Endplatten fixiert sind.

6. Elektrische Wechselrichtereinheit nach Anspruch 5, **dadurch gekennzeichnet, dass** die elektrische Einheit so gestaltet ist, dass sie sowohl Gleichstrom- als auch Wechselstromflüsse steuert, wobei der der Einheit zugeführte Gleichstrom mit einem oder mehreren der Ansätze oder Flansche an den Endplatten (109) verbunden ist, um die Wärmeableitung von der Kombination aus Wechsel- und Gleichstrom in der Einheit zu optimieren.

7. Elektrische Wechselrichtereinheit nach Anspruch 6, **dadurch gekennzeichnet, dass** die Endplatten (109) an einer oder mehreren thermisch leitfähigen Kühlplatten unter Verwendung einer elektrisch isolierenden und thermisch leitfähigen Schicht (108) fixiert sind.

8. Elektrische Wechselrichtereinheit nach Anspruch 1 oder 2, wobei dieses ferner folgendes umfasst: eine erste elektrische Gleichstromverbindung (115A), die sich in dem inneren Durchmesser an einer ersten der entgegengesetzten Stirnseiten des DC-Link-Kondensators (101) befindet, und eine zweite elektrische Gleichstromverbindung (115B), die sich in dem inneren Durchmesser an einer zweiten der entgegengesetzten Stirnseiten des DC-Link-Kondensators (101) befindet, wobei eine Mehrzahl von Gleichstromverbindungspunkten gleichmäßig um den inneren Umfang des Kondensators (101) verteilt ist, wobei die elektrisch leitenden Kontakte eine Anordnung elektrischer Ansätze oder eine scheibenförmige Dauerelektrode umfassen.

9. Elektrische Wechselrichtereinheit nach einem der Ansprüche 2 bis 8, **dadurch gekennzeichnet, dass** Gleichstrom der Einheit zugeführt oder von dieser entfernt wird durch eine elektrische Verbindung, die gebildet wird durch eine elektrisch und thermisch leitfähige Kühlplatte (109), die in Kontakt mit einer Stirnseite des Kondensators (101) platziert ist, wobei Gleichstrom von der Einheit entfernt oder der Einheit zugeführt wird durch eine elektrische Verbindung (105), die sich in dem inneren Durchmesser an der entgegengesetzten Stirnseite des Kondensators (101) befindet, wobei die Gleichstromverbindungspunkte gleichmäßig um den inneren Umfang des Kondensators verteilt sind, und wobei die Gleichstromkontakte ausgewählt sind aus der Liste, welche elektrische Ansätze oder eine scheibenförmige Dauerelektrode umfasst.

10. Elektrische Wechselrichtereinheit nach einem der Ansprüche 1, 2 und 8, wobei der DC-Link-Kondensator (101) mit gewickelter Folie einen Kondensator mit monolithisch gewickelter Folie umfasst.

11. Elektrische Wechselrichtereinheit nach einem der Ansprüche 1, 2 und 8, wobei dieser ferner eine thermisch und elektrisch leitfähige Kühlplatte (109) umfasst, die mit den elektrisch leitfähigen Kontakten und mit der einen oder den mehreren elektrischen Leistungssteuerungskomponenten (102; 106A, 106B) verbunden ist, um dazwischen eine elektrische Verbindung bereitzustellen.

## Revendications

1. Ensemble onduleur de puissance électrique, comprenant :
un condensateur de liaison CC à film bobiné (101) sous la forme d'une bague annulaire ayant un diamètre extérieur supérieur à une épaisseur de ladite bague annulaire et un diamètre intérieur, ladite bague annulaire ayant une profondeur ;
une pluralité de contacts électroconducteurs (103, 104) répartis de façon égale autour de la bague annulaire (101) sur des faces d'extrémité opposées dudit condensateur de liaison CC (101) ; et
**caractérisé en ce qu'**il comprend
au moins un composant de commande de puissance électrique (102 ; 106A, 106B) réparti autour d'une circonférence intérieure ou extérieure de ladite bague annulaire et connecté électriquement avec lesdits contacts (103, 104) sur ledit condensateur de liaison CC (101) pour effectuer une réduction de l'inductance de circuit et pour distribuer de manière uniforme le courant dans le condensateur de liaison CC (101) afin de minimiser les pertes de puissance, et ladite profondeur annulaire étant sélectionnée pour minimiser la longueur de ladite connexion électrique entre chacun des composants de commande de puissance électriques et lesdits contacts électriquement conducteurs auxquels elle est connectée.

2. Ensemble onduleur de puissance électrique selon la revendication 1 comprenant en outre au moins une carte de circuits imprimés (109) connectée sélectivement à ladite pluralité de contacts électriquement conducteurs (103, 104) sur ledit condensateur de liaison CC (101) et audit au moins un composant de commande de puissance électrique (102 ; 106A, 106B) pour effectuer ladite connexion électrique entre ceux-ci.

3. Ensemble onduleur de puissance électrique selon l'une quelconque des revendications 1 et 2, comprenant en outre au moins une plaque thermiquement et électriquement conductrice (109 ; 118, 119) pour fournir une connexion électrique et thermique à l'une ou aux deux faces frontales opposées dudit condensateur à liaison CC (101).

4. Ensemble onduleur de puissance électrique selon la revendication 3, comprenant en outre au moins une couche de matériau électriquement isolant et thermiquement conducteur (108) entre l'une ou les deux faces d'extrémité opposées dudit condensateur (101) et lesdites plaques thermiquement et électriquement conductrices pour fournir une isolation électrique entre celles-ci.

5. Ensemble inverseur de puissance électrique selon l'une quelconque des revendications 1 à 4, **caractérisé en ce qu'**au moins une plaque d'extrémité électriquement et thermiquement conductrice (109) est connectée aux faces d'extrémité opposées dudit condensateur (101), lesdites plaques d'extrémité (109) étant sensiblement plus grandes que les faces d'extrémité dudit condensateur (101), lesdites plaques d'extrémité (109) étant placées pour être décalées les unes des autres, lesdites plaques ayant des languettes ou brides qui dépassent du diamètre extérieur du périmètre extérieur dudit condensateur afin d'établir la connexion audit composant électrique (102 ; 106A, 106B), et lesdits composants de commande de puissance électrique étant fixés auxdites plaques d'extrémité.

6. Ensemble onduleur de puissance électrique selon la revendication 5, **caractérisé en ce que** ledit ensemble électrique est conçu pour commander à la fois le courant continu et le courant alternatif, le courant continu introduit dans l'ensemble étant connecté à au moins une desdites pattes ou brides sur lesdites plaques d'extrémité (109) pour optimiser la dissipation thermique de la combinaison du courant alternatif et continu de l'ensemble.

7. Ensemble onduleur de puissance électrique selon la revendication 6, **caractérisé en ce que** lesdites plaques d'extrémité (109) sont fixées à au moins une plaque de refroidissement thermiquement conductrice à l'aide d'une couche électriquement isolante et thermiquement conductrice (108).

8. Ensemble onduleur de puissance électrique selon l'une quelconque des revendications 1 et 2, comprenant en outre une première connexion électrique CC (115A) située dans ledit diamètre intérieur sur une première desdites faces d'extrémité opposées dudit condensateur de liaison CC (101) et une seconde connexion électrique CC (115B) située dans ledit diamètre intérieur sur une seconde desdites faces d'extrémité opposées dudit condensateur (101), une pluralité de points de connexion CC étant également répartis sur ladite périphérie intérieure dudit condensateur (101), lesdits contacts électriquement conducteurs comprenant une série de pattes électriques ou une électrode en forme de disque.

9. Ensemble onduleur de puissance électrique selon l'une quelconque des revendications 2 à 8, **caractérisé en ce qu'**un courant continu est introduit dans ledit ensemble ou en est retiré par une connexion électrique formée par une plaque froide électriquement et thermiquement conductrice (109) placée en contact avec une face avant dudit condensateur (101), le courant continu étant retiré dudit ensemble ou introduit dans celui-ci par l'intermédiaire d'une connexion électrique (105) située à l'intérieur du diamètre intérieur sur la face d'extrémité opposée dudit condensateur (101), les points de connexion du courant continu étant également répartis sur la circonférence intérieure dudit condensateur, et les contacts du courant continu étant choisis parmi la liste comprenant des languettes électriques ou une électrode continue en forme de disque.

10. Ensemble onduleur de puissance électrique selon l'une quelconque des revendications 1, 2 et 8, ledit condensateur à liaison CC à film enroulé (101) comprenant un condensateur monolithique à film enroulé.

11. Ensemble onduleur de puissance électrique selon l'une quelconque des revendications 1, 2 et 8, comprenant en outre une plaque froide (109) thermiquement et électriquement conductrice connectée auxdits contacts électriquement conducteurs et audit au moins un composant de commande de puissance électrique (102 ; 106A, 106B) pour assurer ladite connexion électrique entre eux.
